# EUROPÄISCHE PATENTSCHRIFT

(11) **EP 1 575 347 B1**
(45) Veröffentlichungstag und Bekanntmachung des Hinweises auf die Patenterteilung: **23.04.2008**
(21) Anmeldenummer: 05004888.3
(22) Anmeldetag: 05.03.2005
(51) Int. Cl.: H05K 9/00

(54) **Federblech in einem Gehäuse als Abschirmung für ein elektronisches hochfrequenztechnisches Gerät**
Contact spring in a casing which is used as shield for an electronic high frequency unit
Plaque ressort dans un boîtier faisant fonction d'écran pour un appareil électronique haute fréquence

(30) Priorität: 12.03.2004 DE 102004012565; 03.03.2005 DE 102005010271
(43) Veröffentlichungstag der Anmeldung: 14.09.2005
(62) Teilanmeldung aus: 05013745.4
(73) Patentinhaber: Hirschmann Electronics GmbH, 72654 Neckartenzlingen (DE)
(72) Erfinder: Adam, Thomas, 72574 Bad Urach (DE); Silva, David, 72622 Nürtingen (DE)
(74) Vertreter: Thul, Hermann

(56) Entgegenhaltungen:
- EP-A- 0 563 673
- EP-A- 0 696 161
- EP-A- 0 762 822
- EP-A- 1 381 264
- DE-A1- 3 529 105
- US-A- 6 053 771

## Beschreibung

Die Erfindung betrifft ein elektronisches hochfrequenztechnisches Gerät mit einem Gehäuse aus einem elektrisch leitfähigen Material gemäß den Merkmalen des Patentanspruchs 1.

In diesem Gehäuse des elektronischen Gerätes ist zur Realisierung der Funktion des elektronischen Gerätes zumindest ein elektronisches Modul, insbesondere mehrere Teilmodule, untergebracht. Diese Teilmodule können auf einer gemeinsamen Leiterplatte (Motherboard) angeordnet werden. Diese Anordnung kann beispielsweise über Steckverbinder erfolgen, so dass die Teilmodule, die ihrerseits aus Leiterplatten mit elektronischen Bauteilen bestehen, auf das Motherboard aufgesteckt werden. Aufgrund der Anwendung des elektronischen Gerätes im Hochfrequenzbereich ist es erforderlich, die einzelnen Module untereinander abzuschirmen, um Störungen bei deren Funktion und gegenseitige Beeinflussungen zu vermeiden. Hierzu ist schon vorgeschlagen worden, die einzelnen Module untereinander mittels Abschirmbleche hochfrequenzmäßig voneinander zu trennen bzw. mit einem Abschirmgehäuse zu umgeben. Diese Abschirmbleche bzw. Abschirmgehäuse werden auf dem Motherboard mit Masse kontaktiert, was zu einem gewissen Grad an Abschirmung führt, der allerdings noch nicht befriedigend ist. Außerdem ist es bekannt, dass die Abschirmteile unlösbar mit der Leiterplatte verbunden werden. Dies hat im Defektfall den Nachteil, dass das Abschirmteil nur unter Zerstörung von der Leiterplatte gelöst werden kann oder der Ablöseprozess äußerst aufwändig ist. Dies hat zur Folge, dass sich der Austausch eines defekten elektronischen Modules oder Teilmodules nicht mehr lohnt, da er zu teuer ist.

Aus der EP-A-0 563 673 ist ein Steckergehäuse und eine Gehäusewand eines elektrischen Gerätes bekannt, wobei ein dünnes Federblech aus geeignetem Kontaktmaterial zwischen dem metallischen Steckergehäuse und der Gehäusewand des elektrischen Gerätes eingelegt ist. Damit ist das Federblech zum elektrischen Kontaktieren zweier großflächig gegeneinander verspannter Gehäuseteile ausgebildet, wobei sich das Federblech über den Kontaktierbereich erstreckt und zwischen die Gehäuseteile eingelegt wird und beidseitig eine Vielzahl von federnd nachgiebigen Kontakt gebenden Erhebungen aufweist, wobei das Federblech weiterhin mit einer Vielzahl von freigeschnittenen Zungen versehen ist, die nach beiden Seiten ausgebogene Abschnitte aufweisen, die die Kontakt gebenden Erhebungen bilden, wobei die Zungen so verformt sind, dass ihre höchsten Stellen in ihrem Kantenbereich liegen und wobei die Zungen kammartig aneinandergereiht angeordnet und um ihre Längsachse abwechselnd in entgegengesetzter Richtung verdreht sind.

Der Erfindung liegt daher die Aufgabe zugrunde, ein elektronisches Gerät mit einem Gehäuse für hochfrequenztechnische Anwendungen bereitzustellen, bei dem die Abschirmung von Modulen oder Teilmodulen innerhalb des Gehäuses verbessert ist, um gegenseitige Beeinflussungen deutlich zu reduzieren, sowie bei dem einfache Montage- und auch Demontageschritte gegeben sind.

Erfindungsgemäß ist vorgesehen, dass Mittel vorgesehen sind, die zwischen dem Gehäuse und dem zumindest einen Abschirmteil angeordnet sind und eine elektrische Kontaktierung zwischen dem Gehäuse und dem zumindest einen Abschirmteil herstellen. Diese Mittel, die ebenfalls aus einem elektrisch leitfähigem Material bestehen, genau so wie das Gehäuse und das Abschirmteil, bewirken eine elektrische Kontaktierung, wodurch die Abschirmbleche bzw. die Abschirmgehäuse, mit denen die innerhalb des Gehäuses angeordneten Teilmodule umgeben sind, bei der Montage des Gehäuses automatisch elektrisch kontaktiert werden und damit automatisch eine zusätzliche Masseverbindung hergestellt wird. Über diese zusätzliche Masseverbindung über diese Mittel und das elektrisch leitfähige Gehäuse können störende hochfrequente Ströme abgeleitet werden, so dass sie nicht mehr in die Elektronik der Teilmodule einstrahlen.

Diese Mittel zur Kontaktierung werden entweder unlösbar (z. B. durch Verkleben mit einem elektrisch leitfähigen Kleber) oder lösbar (z. B. durch Verclipsen, Verstemmen, Verschrauben oder dergleichen) mit dem Gehäuse verbunden. Die Mittel zur Kontaktierung sind elastisch verformbar, so dass sie dann, wenn sie zwischen dem Abschirmblech (oder dem Abschirmgehäuse) und dem Gehäuse des elektronischen Gerätes angeordnet sind, bei der Montage des Gehäuses verformt werden und somit ein Anlagedruck erzeugt wird. Dieser stellt eine erhöhte Kontaktsicherheit dar.

Besonders wichtig bei den Mitteln zur elektrischen Kontaktierung zwecks Herstellung einer Masseverbindung ist die kostengünstige und einfache Serienherstellung.

Ein Ausführungsbeispiel für die erfindungsgemäße einfache und kostengünstige Kontaktierung bzw. Montage, auf die die Erfindung jedoch nicht beschränkt ist, sind im Folgenden beschrieben und anhand der Figuren erläutert.

Es zeigen:
- Figur 1:: ein Gehäuse eines elektronischen Gerätes mit einem Federblech,
- Figur 2:: Detailansichten des Federbleches,

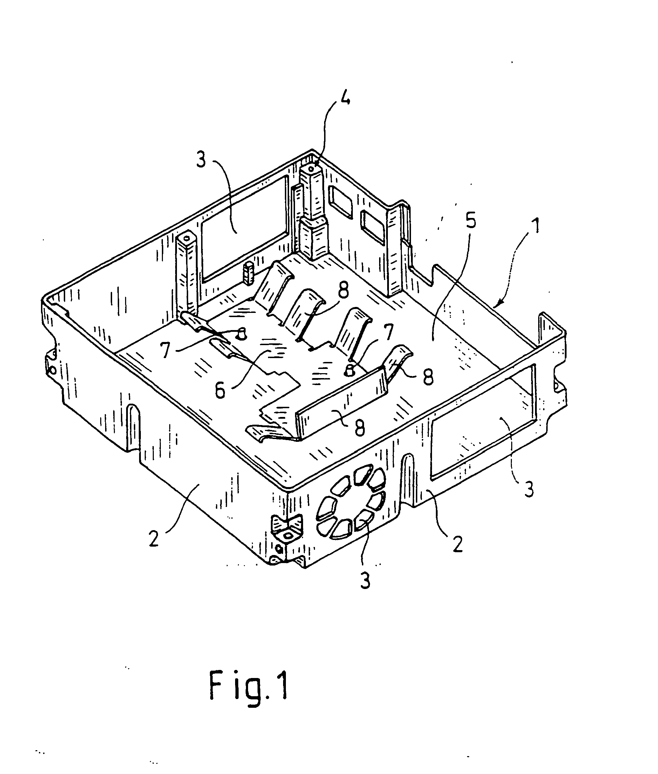

Figur 1 zeigt, soweit im Einzelnen dargestellt, ein Gehäuse 1 eines elektronischen Gerätes für hochfrequenztechnische Anwendungen, so zum Beispiel ein TV-Tuner für den Fernsehempfang, hier insbesondere wieder zur Anwendung bei Fahrzeugen. Dieses Gehäuse 1 ist Bestandteil eines mehrteiligen Gesamtgehäuses, das beispielsweise aus dem Gehäuse 1 als Deckel und einem damit verbindbaren Boden besteht. Der Boden nimmt eine Grundplatine (Motherboard) auf, auf der wiederum mittels Steckverbindungen Teilmodule angeordnet sind. Diese Teilmodule sind beispielsweise senkrecht auf der Grundplatine angeordnet und stehen somit von dieser ab. Bekannt ist es, diese Teilmodule mit einer Abschirmung zu versehen, wobei diese Abschirmung beispielsweise als zwischen den Teilmodulen angeordnete Abschirmbleche ausgebildet ist. Ergänzend oder alternativ dazu können die Teilmodule von einem Abschirmgehäuse umgeben sein. Diese Abschirmbleche oder Abschirmgehäuse sind elektrisch mit einer Masse der Grundplatine kontaktiert. Das in Figur 1 gezeigte Gehäuse 1 weist Seitenteile 2 auf, in denen entsprechend ihrer Funktion Öffnungen 3 angeordnet sind. Bei den Öffnungen 3 handelt es sich beispielsweise um Öffnungen für die Aufnahme von Steckverbindungen, Lüfter und dergleichen. Insbesondere in den vier Ecken des Gehäuses 1 sind Gewindebohrungen 4 angeordnet, mit denen das Gehäuse 1 mit dem Boden verschraubbar ist. Das Gehäuse 1 weist neben den vier Seitenteilen 2 einen Gehäusedeckel 5 auf, an dem Mittel zur elektrischen Kontaktierung der Abschirmbleche bzw. der Abschirmgehäuse mit dem Gehäuse 1 angeordnet sind. Bei diesen Mitteln handelt es sich um ein ein- oder mehrteiliges Federblech 6, welches hier als einteiliges Federblech 6 dargestellt ist. Ein solches Federblech kann einfach im Stanzbiegeverfahren aus einem Metallblech hergestellt werden. Zur Fixierung des Federbleches 6 an dem Gehäuse 1 weist der Gehäusedeckel 5 ein oder mehrere Stifte 7 auf, die insbesondere mit der Herstellung des Gehäuses 1 dort angeordnet werden. Über diese Stifte 7 und korrespondierende Öffnungen in dem Federblech 6 wird dieses durch Aufdrücken auf die Stifte 7 an dem Gehäusedeckel 5 festgelegt. Gegebenenfalls kann eine mechanische Nachbearbeitung (Verformen) der Stifte 7 erfolgen. Das Federblech 6 wiederum hat in Richtung des Inneren des Gehäuses 1 abstehende Laschen 8, die beim Aufsetzen des Gehäuses 1 auf seinen hier nicht dargestellten Boden in Anlage mit den Abschirmblechen oder den Abschirmgehäusen kommen, um eine elektrische Kontaktierung herzustellen.

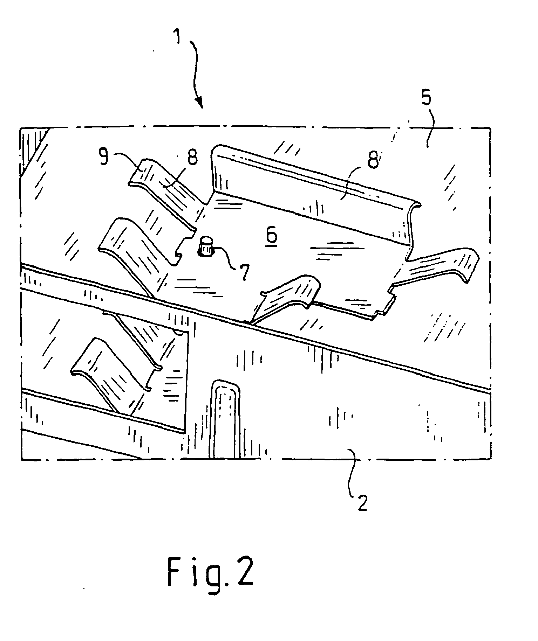

Figur 2 zeigt das Federblech 6 gemäß Figur 1, wobei hier noch einmal deutlich die vom Gehäusedeckel 5 abstehenden Laschen 8 erkennbar sind. Zur Erleichterung der Montage weisen diese Laschen 8 abgerundete Endbereiche 9 auf, so dass die Laschen 8 mit ihren abgerundeten Endbereichen 9 beim Zusammenbau des Gehäuses über die Abschirmbleche bzw. die Abschirmgehäuse gleiten können. Das Federblech 6 läßt sich einfach im Stanzbiegeverfahren herstellen und ist somit bezüglich seiner Herstellung und Montage sehr kostengünstig, was sich gerade für eine Serienherstellung von elektronischen Geräten anbietet. Anstelle des in den Figuren 1 und 2 dargestellten einteiligen Federbleches 6 ist es auch denkbar, mehr als ein Federblech 6 über zugehörige Stifte 7 an dem Gehäuse 1, also auch an den Seitenteilen 2, anzuordnen.

Anstelle der Anordnung eines Federbleches an einem Teil des Gehäuses 1 ist es auch denkbar, das Abschirmblech bzw. das Abschirmgehäuse mit den Mitteln zur Kontaktierung zu versehen, um eine elektrische Verbindung zwischen diesen und dem Gehäuse herzustellen. So könnte beispielsweise das Abschirmblech oder das Abschirmgehäuse, welches innerhalb des Gehäuses 1 angeordnet ist, seinerseits mit einer federnden Lasche versehen sein oder eine solche federnde Lasche an dem Blech oder dem Gehäuse angeordnet werden.

Weiterhin ist vorgesehen, dass das Abschirmteil als Abschirmkäfig ausgebildet ist. Dieser Abschirmkäfig wird auf der Leiterplatte in der vorstehend beschriebenen Weise festgelegt und umgibt damit das elektronische Modul, d.h., die elektronischen Bauteile, die auf der Leiterplatte angeordnet sind, zwecks Abschirmung. Mit diesem Abschirmkäfig wird also wirksam verhindert, dass einerseits von dem elektronischen Modul Störstrahlungen ausgesandt werden, andererseits wird aber auch wirksam verhindert, dass Störstrahlungen von außerhalb, z.B. von anderen elektronischen Modulen, in das mit dem Abschirmkäfig abgeschirmte elektronische Modul einstrahlen können. Zwecks Abschirmung ist es also erforderlich, dass zumindest eine elektronische Modul innerhalb des Gehäuses mit dem Abschirmkäfig zu versehen. Im Regelfall werden innerhalb des Gehäuses mehrere elektronische (Teil-) Module angeordnet sein, die jeweils einen Abschirmkäfig aufweisen oder zwischen denen ein Abschirmblech angeordnet ist. Da zur Sicherstellung der Abschirmung das Abschirmteil auf einem bestimmten elektrischen Potenzial (insbesondere Masse) liegen muss, werden erfindungsgemäß zur Montage und gleichzeitigen elektrischen Kontaktierung die vorgeschlagenen Lösungen realisiert. Diese Kontaktierung erfolgt in besonders vorteilhafter Weise, wenn das elektronische Modul mit dem Abschirmteil in das Gehäuse 1 eingesetzt wird bzw. das elektronische Modul schon auf einer Grundplatte des Gehäuses 1 montiert ist und anschließend das Gehäuse 1 zum Verschließen montiert wird.

Die erfindungsgemäßen Mittel zur elektrischen Kontaktierung zwischen dem Abschirmteil und dem Gehäuse 1 haben in allen Varianten den Vorteil, dass sie einfach und kostengünstig, insbesondere in einem Stanzverfahren oder einem Stanzbiegeverfahren, herstellbar sind und gleichzeitig eine Demontage bestehen bleibt, ohne dass es zu einer aufwändigen Demontage oder einer Zerstörung der beteiligten Teile kommt.

### Bezugszeichenliste

1. Gehäuse
2. Seitenteile
3. Öffnungen
4. Gewindebohrung
5. Gehäusedeckel
6. Federblech
7. Stift
8. Lasche
9. abgerundeter Endbereich

## Patentansprüche

1. Elektronisches hochfrequenztechnisches Gerät mit einem Gehäuse (1) aus einem elektrisch leitfähigen Material, wobei in dem Gehäuse (1) zumindest ein elektronisches Modul sowie ein zugeordnetes Abschirmteil angeordnet ist, **dadurch gekennzeichnet, dass** Mittel vorgesehen sind, die zwischen dem Gehäuse (1) und dem zumindest einen Abschirmteil angeordnet sind und eine elektrische Kontaktierung zwischen dem Gehäuse (1) und dem zumindest einen Abschirmteil herstellen, wobei die Kontaktierung erfolgt, wenn das elektronische Modul mit dem Abschirmteil in das Gehäuse (1) eingesetzt wird oder wenn das elektronische Modul schon auf einer Grundplatte des Gehäuses (1) montiert ist und anschließend das Gehäuse (1) zum Verschließen montiert wird.

2. Gerät nach Anspruch 1, **dadurch gekennzeichnet, dass** die Mittel als ein Federblech (6) ausgebildet sind.

3. Gerät nach Anspruch 2, **dadurch gekennzeichnet, dass** das Federblech (6) zumindest eine abstehende Lasche (8), insbesondere mehrere Laschen (8), aufweist.

4. Gerät nach Anspruch 3, **dadurch gekennzeichnet, dass** die zumindest eine Lasche (8) einen abgerundeten Endbereich (9) aufweist.

5. Gerät nach einem der vorhergehenden Ansprüche, **dadurch gekennzeichnet, dass** die Mittel, insbesondere das Federblech (6), lösbar oder unlösbar an dem Gehäuse (1) oder an dem Abschirmteil befestigt sind.

6. Gerät nach einem der vorhergehenden Ansprüche, **dadurch gekennzeichnet, dass** das Abschirmteil als Aschirmblech oder Abschirmkäfig ausgebildet ist.

## Claims

1. Electronic high-frequency device having a housing (1) made from an electrically conducting material, at least one electronic module and an associated screen section being arranged in the housing (1), **characterized in that** means are provided, which are arranged between the housing (1) and the at least one screen section and which make an electrical contact between the housing (1) and the at least one screen section, contact being made when the electronic module is placed in the housing (1) together with the screen section or when the electronic module is already mounted on a base plate of the housing (1) and the housing (1) is subsequently assembled for sealing.

2. Device according to Claim 1, **characterized in that** the means are designed as a spring steel sheet (6).

3. Device according to Claim 2, **characterized in that** the spring steel sheet (6) has at least one protruding lug (8), in particular several lugs (8).

4. Device according to Claim 3, **characterized in that** the at least one lug (8) has a rounded end region (9).

5. Device according to one of the preceding claims, **characterized in that** the means, in particular the spring steel sheet (6), are removably or non-removably fixed to the housing (1) or to the screen section.

6. Device according to one of the preceding claims, **characterized in that** the screen section is designed as a screen plate or screen cage.

## Revendications

1. Appareil électronique à haute fréquence comprenant un boîtier (1) en un matériau électriquement conducteur, au moins un module électronique ainsi qu'une pièce de blindage associée étant disposés dans le boîtier (1), **caractérisé en ce que** des moyens sont prévus, lesquels sont disposés entre le boîtier (1) et l'au moins une pièce de blindage et établissent un contact électrique entre le boîtier (1) et l'au moins une pièce de blindage, le contact étant établi lorsque le module électronique muni de la pièce de blindage est introduit dans le boîtier (1) ou lorsque le module électronique est déjà monté sur une plaque de base du boîtier (1) et le boîtier (1) est ensuite monté en vue de la fermeture.

2. Appareil selon la revendication 1, **caractérisé en ce que** les moyens sont réalisés sous la forme d'une tôle souple (6).

3. Appareil selon la revendication 2, **caractérisé en ce que** la tôle souple (6) présente au moins une éclisse (8) faisant saillie, notamment plusieurs éclisses (8).

4. Appareil selon la revendication 3, **caractérisé en ce que** l'au moins une éclisse (8) présente une zone d'extrémité arrondie (9).

5. Appareil selon l'une des revendications précédentes, **caractérisé en ce que** les moyens, notamment la tôle souple (6), sont fixés au boîtier (1) ou à la pièce de blindage de manière amovible ou inamovible.

6. Appareil selon l'une des revendications précédentes, **caractérisé en ce que** la pièce de blindage est réalisée sous la forme d'une tôle de blindage ou d'une cage de blindage.
